# EUROPÄISCHE PATENTSCHRIFT

(11) **EP 0 886 994 B1**
(45) Veröffentlichungstag und Bekanntmachung des Hinweises auf die Patenterteilung: **11.08.1999**
(21) Anmeldenummer: 97903267.9
(22) Anmeldetag: 13.02.1997
(51) Int. Cl.: H05K 7/20

(54) **SCHALTSCHRANK MIT SCHRANKTÜRE UND KÜHLGERÄT**
CONTROL BOX WITH DOOR AND COOLER
ARMOIRE DE COMMANDE AVEC PORTES ET DISPOSITIF DE REFROIDISSEMENT

(30) Priorität: 13.03.1996 DE 19609794
(43) Veröffentlichungstag der Anmeldung: 30.12.1998
(73) Patentinhaber: Rittal-Werk Rudolf Loh GmbH & Co. KG, 35745 Herborn (DE)
(72) Erfinder: MÜLLER, Norbert, D-35716 Dietzhölztal (DE); STRACKBEIN, Heinrich, D-35444 Bieberteil (DE); BERNHARDT, Jürgen, D-35708 Haiger (DE); NICOLAI, Walter, D-35418 Buseck (DE)
(74) Vertreter: Fleck, Hermann-Josef, Dr.-Ing.
(86) Internationale Anmeldenummer: EP9700658
(87) Internationale Veröffentlichungsnummer: WO9734455

(56) Entgegenhaltungen:
- FR-A- 2 085 219
- GB-A- 2 277 767
- US-A- 3 559 728
- ENGENEERING & AUTOMATION NEWS 9 (SIEMENS), Nr. 2, Juni 1989, Seiten 15-18, XP000045912 HERMANN KLÄRNER: "Air-Conditioning for Electronic Equipment Cubicles"

## Beschreibung

Die Erfindung betrifft einen Schaltschrank mit einem mittels Schranktüre verschließbaren Schrankkorpus und einem Kühlgerät mit einem aus Lüfter und Verdampfer bestehenden Innenkreislauf und einem aus Kompressor, Verflüssiger und Lüfter bestehenden Außenkreislauf, wobei das Kühlgerät mit einem wannenförmigen, am Schrankkorpus anlenkbaren und an diesem verschließbaren Gehäuseaußenteil und mit einer dieses abdeckenden Trägerplatte versehen ist, wobei der von dem Gehäuseaußenteil und der Trägerplatte umschlossene Raum einen oberen und einen unteren Aufnahmeraum bilden, und wobei die Trägerplatte im Bereich des oberen Aufnahmeraumes Luftansaugöffnungen und darunter eine Luftaustrittsöffnung für den Innenkreislauf aufweist.

Es ist bekannt, das Kühlgerät anstelle eines Wandelementes am Schrankkorpus anzubringen.

Eine derartige Ausgestaltung eines Schaltschrankes ist aus der US 3,559,728 bekannt. Bei diesen Schaltschränken weist das Kühlgerät ein wannenförmiges Gehäuseaußenteil auf, das in zwei Kammern unterteilt ist. Jede der Kammern nimmt Kühlgerätebaugruppen des Kühlkreislaufs auf. Die erste Kammer steht mit der Umgebung in Verbindung, während die zweite Kammer dem Innenraum des Schaltschrankes zugekehrt ist.

Aus der FR-A-2 085 219 ist ein Kühlgerät bekannt, das als Wandeinbaugerät ausgebildet ist. Als solches steht es in dem Innenraum des Schaltschrankes vor und verkleinert damit das Einbauvolumen des Schaltschrankes.

Aus GB-A-2 277 767 ist ferner ein Schaltschrank bekannt, wobei ein Regelsystem für Umgebungsbedingungen in der Tür des Schaltschrankes eingebaut ist. Die Tür weist zwei Lüfter und einen Wärmetauscher auf. Die Frischluft wird frontseitig angesangt und abgeleitet.

Es ist Aufgabe der Erfindung, einen Schaltschrank der eingangs erwähnten Art so auszugestalten, daß das Kühlgerät wie eine Schranktüre mit dem Schrankkorpus verbunden werden kann, wobei insbesondere den beiden Anschlagarten - links oder rechts angeschlagen - Rechnung getragen werden kann.

Diese Aufgabe wird nach der Erfindung dadurch gelöst, daß das Kühlgerät als Schranktüre ausgebildet ist, daß in dem nach oben offenen, oberen Aufnahmeraum die Kühlgerät-Baugruppen des Innenkreislaufes angeordnet, auf der Trägerplatte befestigt und zu dieser hermetisch abgedeckt sind, daß in dem nach unten offenen, unteren Aufnahmeraum die Kühlgerät-Baugruppen des Außenkreislaufes angeordnet und mit der Trägerplatte verbunden sind, und daß Frischluft für den Außenkreislauf über die offene untere Seite des unteren Aufnahmeraumes angesaugt, über die Kühlgerät-Baugruppen des Außenkreislaufes geleitet, in den unteren Bereich des oberen Aufnahmeraumes eingeleitet und an der offenen Seite des oberen Aufnahmeraumes abgeleitet wird.

Das Gehäuseaußenteil ersetzt praktisch die Schranktüre und ist wie eine solche am Schrankkorpus anbringbar. Die Trägerplatte trägt alle Baugruppen des Kühlgerätes und ist mit dem Gehäuseaußenteil verbindbar, wobei die Befestigung die Anschlagart des Gehäuseaußenteils am Schrankkorpus berücksichtigen kann, um die Anordnung der Baugruppen des Kühlgerätes unabhängig von der Anschlagart des Kühlgerätes erreichen zu können. Durch die Unterteilung in einen oberen und einen unteren Aufnahmeraum und die Verteilung der Baugruppen von Innen- und Außenkreislauf wird mit der hermetischen Abdeckung der Baugruppen des Innenkresislaufes eine eindeutige Entkopplung der beiden Kreisläufe erreicht, so daß kein Kondenswasser in den Schattschrank gelangen kann. Der Aufbau des Kühlgerätes ist einfach, da alle Baugruppen auf der Trägerplatte befestigt werden können.

Die hermetische Abdeckung der Baugruppen des Innenkreislaufes wird nach einer Ausgestaltung dadurch erreicht, daß die Kühlgerät-Baugruppen des Innenkreislaufes mittels einer Abdeckhaube abgedeckt sind, die mit der dem Schrankinnenraum abgekehrten Seiten der Trägerplatte verbunden ist.

Ist nach einer weiteren Ausgestaltung vorgesehen, daß das Gehäuseaußenteil an den vertikalen Seiten mittels Trennbleche abgeteilte Lüftungskammern auf-weist, daß das Gehäuseaußenteil und die Lüftungskammern mittels Trennwände entsprechend dem oberen und unteren Aufnahmeraum unterteilt sind, und daß die Trennbleche der Lüftungskammern im oberen Aufnahmeraum Lufteintrittsdurchbrüche und im untern Aufnahmeraum Luftaustrittsdurchbrüche aufweisen, dann kann die Luftführung des Außenkreislaufes über beide Aufnahmeräume geführt werden.

Eine Befestigungsmöglichkeit für die Trägerplatte am Gehäuseaußenteil ist da-durch geschaffen, daß die Lüftungskammern zur Trägerplatte parallele Befestigungsabschnitte aufweisen, die mit Befestigungsaufnahmen für eine Befestigung der Trägerplatte in zwei um 180° verdrehten Stellungen versehen sind. Dabei trägt die Verteilung und Anordnung der Befestigungsaufnahmen den beiden Anschlagarten des Kühlgerätes Rechnung. Das Gehäuseaußenteil kann in 180° verdrehten Stellungen am Schrankkorpus angelenkt werden. Die Trägerplatte ist stets so mit dem Gehäuseaußenteil verbindbar, daß der Aufnahmeraum mit dem Innenkreislauf oben liegt.

Nach einer bevorzugten Ausgestaltung ist vorgesehen, daß das Gehäuseaußenteil trapezförmigen Querschnitt aufweist, und daß die darin abgeteilten Lüftungskammern rechtwinklig-dreieckförmigen Querschnitt umschließen. Die trapezförmige Form des Gehäuseaußenteils bringt eine optisch ansprechende Ausgestaltung des Schaltschrankes und die Lüftungskammern versteifen das Gehäuseaußenteil.

Die Erfindung wird anhand eines in den Zeichnungen dargestellten Ausführungsbeispiels näher erläutert. Es zeigen:
- Fig. 1: eine Teilansicht in Perspektive, die das am Schrankkorpus angelenkte Kühlgerät in der Offenstellung erkennen läßt, und
- Fig. 2: schematisch drei senkrecht zueinander stehende Schnitte und Ansichten, denen die Verteilung und Anordnung der Baugruppen des Kühlgerätes zu entnehmen ist.

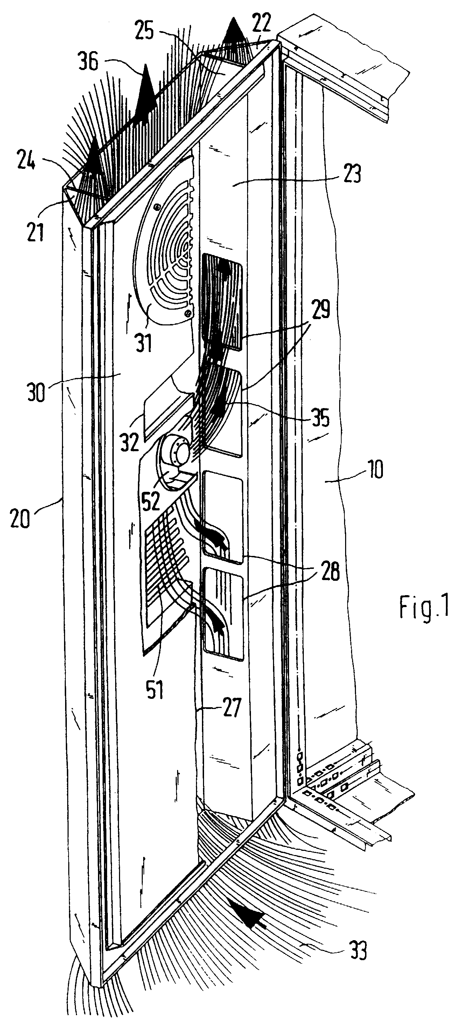

Von dem Schrankkorpus 10 ist in Fig. 1 nur der Teil der Vorderseite gezeigt, an dem das Kühlgerät wie eine Schranktüre angelenkt ist. Das Kühlgerät weist ein wannenartiges Gehäuseaußenteil 20 mit trapezförmigem Querschnitt auf, das in Schließstellung die Außenkontur des Schaltschrankes vervollständigt. Die Anlenkung und das Verschließen des Gehäuseaußenteils 20 am Schrankkorpus erfolgt in an sich bekannter Weise mit an sich bekannten Scharnier- und Schließelementen. Da diese für die vorliegende Erfindung nicht von Bedeutung sind, braucht auf Einzelheiten nicht eingegangen zu werden. Diese Elemente sind in den Zeichnungen deshalb auch nicht dargestellt.

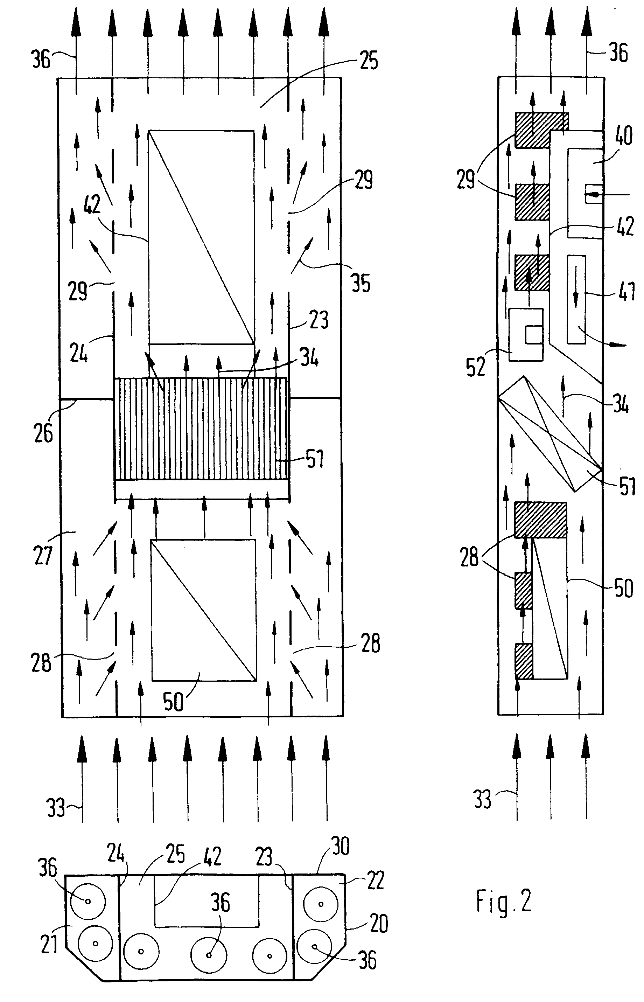

Die dem Innenraum des Schaltschrankes zugekehrte, offene Seite des Gehäuseaußenteils 20 wird mit einer Trägerplatte 30 verschlossen. Diese Trägerplatte 30 umschließt mit dem Gehäuseaußenteil 20 einen Raum, der einen oberen Aufnahmeraum 25 und einen unteren Aufnahmeraum 27 bildet. Die Unterteilung erfolgt dabei vorzugsweise etwa auf halber Höhe des als Schranktüre verwendeten Kühlgerätes. Der obere Aufnahmeraum 25 ist nach oben hin und der untere Aufnahmeraum 27 nach unten hin offen. Im Bereich des oberen Aufnahmeraumes 25 sind in der Trägerplatte 30 die Luftansaugöffnungen 31 und darunter die Luftaustrittsöffnungen 32 des Innenkreislaufes vorgesehen. Auf der dem Innenraum des Schaltschrankes abgekehrten Seite der Trägerplatte 30 sind im oberen Aufnahmeraum 25 die Baugruppen des Innenkreislaufes des Kühlgerätes ein Lüfter 40 und ein Verdampfer 41 angeordnet und auf der Trägerplatte 30 befestigt. Mit einer Abdeckhaube 42 sind diese Baugruppen hermetisch abgedeckt, wie Fig. 2 zeigt. Über den Lüfter 40 wird über die Luftansaugöffnungen 31 die warme Luft aus dem Schaltschrank angesaugt und über den Verdampfer 41 geleitet und gekühlt über die Luftaustrittsöffnung 32 dem Schaltschrank wieder zugeführt.

Im unteren Aufnahmeraum 27 sind auf der Trägerplatte 30 die Baugruppen des Außenkreislaufes, ein Kompressor 50, ein Verflüssiger 51 und ein Lüfter 52 angeordnet und befestigt.

Der Lüfter 52 des Außenkreislaufes saugt Frischluft in den unteren Aufnahmeraum 27. Im Bereich der vertikalen Seiten des Gehäuseaußenteils 20 sind mittels Trennbleche 23 und 24 Lüftungskammern 21 und 22 abgeteilt, die mittels Trennwände 26 entsprechend des oberen und unteren Aufnahmeraumes 25 und 26 entsprechend unterteilt sind.

Der angesaugte Frischluftstrom 33 gelangt nicht nur in den unteren Aufnahmeraum 27, sondern auch in die unteren Teile der Lüftungskammern 21 und 22. Diese Teilströme treten über die Luftaustrittsdurchbrüche 28 in den unteren Aufnahmeraum 27. Der Frischluftstrom 33 streicht über die Baugruppen 50, 51 und 52 des Außenkreislaufes im unteren Aufnahmeraum 27. Der Lüfter 52 des Außenkreislaufes führt den Frischluftstrom in den oberen Aufnahmeraum 25 und über die Lufteintrittsdurchbrüche 29 in die Lüftungskammern 21 und 22, wie die Pfeile 34 und 35 zeigen. Der Frischluftstrom tritt an den offenen, oberen Seiten von dem oberen Aufnahmeraum 25 und den Lüftungskammern 21 und 22 aus, wie die Pfeile 36 zeigen.

Die Lüftungskammern 21 und 22 sind geschlossen und haben einen rechtwinklig-dreieckförmigen oder einen fünfeckigen Querschnitt. Zu der Trägerplatte 30 parallel Abschnitte der Lüftungskammern 21 und 22 dienen als Befestigungsfläche für die Trägerplatte 30, wobei durchaus Dichtungselemente als Zwischenlage verwendet werden können. Außerdem läßt die Trägerplatte 30 zu den Kanten des Gehäuseaußenteils 20 Randbereiche frei, die die für die Abdichtung zum Schrankkorpus erforderlichen Dichtungselemente tragen oder als Dichtungsstege ausgebildet sind, welche mit Dichtungselementen am Schrankkorpus 10 zusammenarbeiten.

Die Befestigungsflächen für die Trägerplatte 30 sind mit Befestigungsaufnahmen versehen, die ein Anbringen der Trägerplatte 30 in zwei um 180° verdrehten Stellungen an dem Gehäuseaußenteil 20 zulassen. Das Gehäuseaußenteil 20 kann dann links oder rechts an der offenen Vorderseite des Schrankkorpus 10 angelenkt werden. Die Baugruppen 40 und 41 des Innenkreislaufes und die Baugruppen 50, 51 und 52 des Außenkreislaufes können dabei stets in der in Fig. 1 gezeigten Ausrichtung zum Einsatz kommen.

Anhand der Fig. 2 wird in drei schematischen, senkrecht zueinander stehenden Schnitten bzw. Ansichten der Verlauf der Frischluft im Außenkreislauf gezeigt. Der Lüfter 52 ist für das Ansaugen der Frischluft 33 in den unteren Aufnahmeraum 25 und die abgeteilten unteren Bereiche der Lüftungskammern 21 und 22 verantwortlich. Dabei tritt der Teil der angesaugten Frischluft, der über die Lüftungskammern 21 und 22 angesaugt wird, über die Luftaustrittsdurchbrüche 28 der Trennbleche 23 und 24 in den unteren Aufnahmeraum 27 ein. Nach dem Passieren des Kompressors 50 wird die Frischluft über den Verflüssiger 51 geleitet und passiert danach erwärmt den freibleibenden Raum des oberen Aufnahmeraumes 25, der nicht durch die Abdeckhaube 42 belegt ist, wie die Pfeile 34 zeigen. Ein Teil der erwärmten Frischluft tritt über die Lufteintrittsdurchbrüche 29 in die oberen Teile der Lüftungskammern 21 und 22, wie die Pfeile 34 zeigen, so daß sowohl am offenen oberen Ende des oberen Aufnahmeraumes 25 als auch an den oberen Enden der Lüftungskammern 21 und 22 die erwärmte Frischluft abgegeben wird.

## Patentansprüche

1. Schaltschrank mit einem mittels Schranktüre verschließbaren Schrank-korpus und einem Kühlgerät mit einem aus Lüfter und Verdampfer bestehenden Innenkreislauf und einem aus Kompressor, Verflüssiger und Lüfter bestehenden Außenkreislauf, wobei das Kühlgerät mit einem wannenförmigen, am Schrankkorpus anlenkbaren und an diesem verschließbaren Gehäuseaußenteil und mit einer dieses abdeckenden Trägerplatte versehen ist, wobei der von dem Gehäuseaußenteil und der Trägerplatte umschlossene Raum einen oberen und einen unteren Aufnahmeraum bilden, und wobei die Trägerplatte im Bereich des oberen Aufnahmeraumes Luftansaugöffnungen und darunter eine Luftaustrittsöffnung für den Innenkreislauf aufweist, wobei
das Kühlgerät als Schranktüre ausgebildet ist, wobei in dem nach oben offenen, oberen Aufnahmeraum die Kühlgerät-Baugruppen (40,41) des Innenkreislaufes angeordnet, auf der Trägerplatte (30) befestigt und zu dieser hermetisch abgedeckt sind,
wobei in dem nach unten offenen, unteren Aufnahmeraum (27) die Kühlgeräte-Baugruppen (50,51,52) des Außenkreislaufes angeordnet und mit der Trägerplatte (30) verbunden sind, und
wobei Frischluft (33) für den Außenkreislauf über die offene untere Seite des unteren Aufnahmeraumes (27) angesaugt, über die Kühlgeräte-Baugruppen (50,51,52) des Außenkreislaufes geleitet, in den unteren Bereich des oberen Aufnahmeraumes (25) eingeleitet und an der offenen oberen Seite des oberen Aufnahmeraumes (25) abgeleitet wird (36).

2. Schaltschrank nach Anspruch 1,
dadurch gekennzeichnet,
daß die Kühlgerät-Baugruppen (40,41) des Innenkreislaufes mittels einer Abdeckhaube (42) abgedeckt sind, die mit der dem Schrankinnenraum abgekehrten Seite der Trägerplatte (30) verbunden ist.

3. Schaltschrank nach Anspruch 1 oder 2,
dadurch gekennzeichnet,
daß das Gehäuseaußenteil (20) an den vertikalen Seiten mittels Trennbleche (23,24) abgeteilte Lüftungskammern (21,22) aufweist,
daß das Gehäuseaußenteil (20) und die Lüftungskammern (21,22) mittels Trennwänden (26) in dem oberen und unteren Aufnahmeraum (25,27) unterteilt sind, und
daß die Trennbleche (23,24) der Lüftungskammern (21,22) im oberen Aufnahmeraum (25) Lufteintrittsdurchbrüche (29) und im unteren Aufnahmeraum (27) Luftaustrittsdurchbrüche (28) aufweisen.

4. Schaltschrank nach einem der Ansprüche 1 bis 3,
dadurch gekennzeichnet,
daß die Lüftungskammern (21,22) zur Trägerplatte (30) parallele Befestigungsabschnitte aufweisen, die mit Befestigungsaufnahmen für eine Befestigung der Trägerplatte (30) in zwei um 180° verdrehten Stellungen versehen sind.

5. Schaltschrank nach einem der Ansprüche 1 bis 4,
dadurch gekennzeichnet,
daß das Gehäuseaußenteil (20) einen trapezförmigen Querschnitt aufweist, und daß die darin abgeteilten Lüftungskammern (21,22) einen rechtwinklig-dreieckförmigen Querschnitt umschließen.

6. Schaltschrank nach Anspruch 1,
dadurch gekennzeichnet,
daß der Verflüssiger (51) des Außenkreislaufes den oberen und den unteren Aufnahmeraum (25 und 27) abteilt.

7. Schaltschrank nach einem der Ansprüche 1 bis 6,
dadurch gekennzeichnet,
daß die Trennwände (26) in den Lüftungskammern (21,22) im Bereich des Verflüssigers (51) des Außenkreislaufes angeordnet sind.

8. Schaltschrank nach einem der Ansprüche 1 bis 7,
dadurch gekennzeichnet,
daß der Lüfter (52) des Außenkreislaufes unmittelbar über dem Verflüssiger (51) des Außenkreislaufes, jedoch unterhalb der Lufteintrittsdurchbrüche (29) in den Trennblechen (23,24) der Lüftungskammern (21,22) angeordnet ist.

## Claims

1. Switchgear cabinet, having a cabinet body, which is closable by means of a cabinet door, and a cooler having an internal circuit, which comprises ventilator and evaporator, and an external circuit, which comprises compressor, condenser and fan, wherein the cooler is provided with a trough-shaped external housing portion, which is pivotally mountable on the cabinet body and is closable thereon, and provided with a carrier plate covering said external portion, wherein the area surrounded by the external housing portion and the carrier plate forms an upper accommodation area and a lower accommodation area, and wherein the carrier plate has air inlet openings in the region of the upper accommodation area and an air outlet opening for the internal circuit therebeneath, wherein the cooler is configured as the cabinet door, wherein the cooler assemblies (40, 41) of the internal circuit are disposed in the upwardly open, upper accommodation area, secured on the carrier plate (30) and covered hermetically relative to said carrier plate, wherein the cooler assemblies (50, 51, 52) of the external circuit are disposed in the downwardly open, lower accommodation area (27) and connected to the carrier plate (30), and wherein fresh air (33) for the external circuit is drawn-in by suction via the open lower side of the lower accomodation area (27), conducted over the cooler assemblies (50, 51, 52) of the external circuit, introduced into the lower region of the upper accommodation area (25) and discharged (36) at the open upper side of the upper accommodation area (25).

2. Switchgear cabinet according to claim 1, characterised in that the cooler assemblies (40, 41) of the internal circuit are covered by means of a covering hood (42), which is connected to the side of the carrier plate (30) remote from the cabinet interior.

3. Switchgear cabinet according to claim 1 or 2, characterised in that the external housing portion (20) has ventilation chambers (21, 22), which are divided by means of dividing plates (23, 24) at the vertical sides, in that the external housing part (20) and the ventilation chambers (21, 22) are divided by means of dividing walls (26) in the upper and lower accommodation areas (25, 27), and in that the dividing plates (23, 24) of the ventilation chambers (21, 22) have air inlet openings (29) in the upper accommodation area (25) and air outlet openings (28) in the lower accommodation area (27).

4. Switchgear cabinet according to one of claims 1 to 3, characterised in that the ventilation chambers (21, 22) have securing portions, which lie parallel to the carrier plate (30) and are provided with securing receivers for a securement of the carrier plate (30) in two positions rotated through 180°.

5. Switchgear cabinet according to one of claims 1 to 4, characterised in that the external housing portion (20) has a trapezoidal cross-section, and in that the ventilation chambers (21, 22), which are divided therein, surround a cross-section which is in the form of a right-angled triangle.

6. Switchgear cabinet according to claim 1, characterised in that the condenser (51) of the external circuit divides the upper and lower accommodation areas (25 and 27).

7. Switchgear cabinet according to one of claims 1 to 6, characterised in that the dividing walls (26) are disposed in the ventilation chambers (21, 22) in the region of the condenser (51) of the external circuit.

8. Switchgear cabinet according to one of claims 1 to 7, characterised in that the ventilator (52) of the external circuit is disposed directly above the condenser (51) of the external circuit, but beneath the air inlet openings (29) in the dividing plates (23, 24) of the ventilation chambers (21, 22).

## Revendications

1. Armoire de distribution avec un corps d'armoire pouvant être fermé par une porte et avec un dispositif de refroidissement comprenant un circuit intérieur constitué par un ventilateur et par un évaporateur et comprenant un circuit extérieur constitué par un compresseur, un liquéfacteur et un ventilateur, où le dispositif de refroidissement est doté d'un élément de boîtier extérieur en forme de cuve pouvant être articulé sur le corps de l'armoire et permettant de fermer celui-ci, et est doté également d'une plaque de support qui recouvre l'élément de boîtier extérieur, où l'enceinte clôturée par l'élément extérieur de boîtier et la plaque de support constitue une chambre supérieure et une chambre inférieure, et où dans la région de la chambre supérieure, la plaque de support présente des orifices d'aspiration d'air et au-dessous de ces dernières un orifice d'échappement d'air pour le circuit intérieur,
où le dispositif de refroidissement est la porte d'armoire, où dans la chambre supérieure ouverte en haut, les composants (40, 41) du circuit intérieur du dispositif de refroidissement sont fixés sur la plaque de support (30) et sont couverts hermétiquement par rapport à cette dernière, où dans la chambre inférieure (27) ouverte vers le dessous sont disposés les composants (50, 51, 52) du circuit extérieur, qui sont reliés à la plaque de support, et où l'air frais (33) pour le circuit extérieur est aspiré au travers le côté inférieur ouvert de la chambre inférieure (27), est conduit au travers les composants (50, 51, 52) du circuit extérieur, est admis dans la zone inférieure de la chambre supérieure (25) et est évacué (36) par le côté supérieur ouvert de la chambre supérieure (25).

2. Armoire de distribution suivant la revendication 1,
caractérisé
en ce que les composants (40, 41) du circuit intérieur du dispositif de refroidissement sont recouverts par un capot de couverture (42), qui est relié au côté de la plaque de support (30) non orienté vers l'enceinte intérieure de l'armoire.

3. Armoire de distribution suivant la revendication 1 ou la revendication 2,
caractérisé
en ce que l'élément extérieur (20) du boîtier présente des chambres de ventilation (21, 22) subdivisés sur les côtés verticaux au moyen de tôles de séparation (23, 24)
en ce que l'élément extérieur (20) du boîtier et les chambres de ventilation (21, 22) sont au moyen de parois de séparation partagés en une chambre supérieure (25) et en une chambre inférieure (27),
en ce que les tôles de séparation (23, 24) des chambres de ventilation (21, 22) présentent des percements d'admission d'air (29) dans la chambre supérieure et des percements d'échappement d'air (28) dans la chambre inférieure (27).

4. Armoire de distribution suivant l'une quelconque des revendications de 1 à 3,
caractérisée
en ce que les chambres de ventilation (21, 22) présentent des portions de fixation parallèles à la plaque de support (30), portions de fixation qui sont dotées de logements de fixation pouvant occuper deux positions diamétralement opposées pour la fixation de la plaque de support (30).

5. Armoire de distribution suivant l'une quelconque des revendications de 1 à 3,
caractérisée
en ce que l'élément extérieur (20) du boîtier présente une section transversale de forme trapézoïdale, et en ce que mes chambres de ventilation y formées par des tôles de séparation enveloppent une section transversale en forme de triangle rectangle.

6. Armoire de distribution suivant la revendication 1,
caractérisé
en ce que le liquéfacteur (51) du circuit extérieur sépare la chambre supérieure (25) de la chambre inférieure (27).

7. Armoire de distribution suivant l'une quelconque des revendications de 1 à 6,
caractérisée
en ce que les parois de séparation (26) dans les chambres de ventilation (21, 22) sont disposées dans la région du liquéfacteur (51) du circuit extérieur.

8. Armoire de distribution suivant l'une quelconque des revendications de 1 à 7,
caractérisée
en ce que le ventilateur (52) du circuit extérieur est disposé directement au-dessus du liquéfacteur (51) du circuit extérieur, mais toutefois au-dessous des percements d'admission d'air (29) dans les tôles de séparation (23, 24) des chambres de ventilation (21, 22).
